# EUROPÄISCHE PATENTSCHRIFT

(11) **EP 2 234 464 B1**
(45) Veröffentlichungstag und Bekanntmachung des Hinweises auf die Patenterteilung: **14.12.2016**
(21) Anmeldenummer: 10002510.5
(22) Anmeldetag: 10.03.2010
(51) Int. Cl.: H05K 1/02, A47L 9/28, H01R 13/66, H05K 3/22, H05K 3/30, H01R 12/00

(54) **Portable elektrische Maschine mit einem Leiterplattenmodul**
Portable electric machine with a PCB module
Machine électroportative dotée d'un module de cartes de circuits imprimés

(30) Priorität: 27.03.2009 DE 102009014707
(43) Veröffentlichungstag der Anmeldung: 29.09.2010
(73) Patentinhaber: Festool GmbH, 73240 Wendlingen am Neckar (DE)
(72) Erfinder: Maier, Frank, 72622 Nürtingen (DE); Fischer, Helmut, 89195 Staig (DE); Barabeisch, Markus, 89269 Vöhringen (DE)
(74) Vertreter: Patentanwälte Bregenzer und Reule Partnerschaftsgesellschaft mbB

(56) Entgegenhaltungen:
- US-A- 4 536 826
- US-A- 5 434 749
- US-B1- 6 302 709

## Beschreibung

Die Erfindung betrifft eine portable elektrische Maschine, insbesondere eine Hand-Werkzeugmaschine oder ein Sauggerät, mit einem Leiterplattenmodul gemäß dem Oberbegriff des Anspruchs 1.

Ein derartiges Leiterplattenmodul geht aus US 5,434,749 hervor.

Leiterplatten mit elektrischen Komponenten, beispielsweise Mikroprozessoren, Widerständen und dergleichen, sind bei elektrischen Vorrichtungen, beispielsweise elektrischen Hand-Werkzeugmaschinen, Sauggeräten und dergleichen, üblich. Ferner ist es notwendig, diese Maschinen mit elektrischen Versorgungsspannungen, beispielsweise zum Betrieb eines Elektromotors, insbesondere eines Saugmotors oder eines Motors zum Antrieb einer Werkzeugspindel, zu versorgen, wofür höhere Spannungspegel erforderlich sind. Auch das zugeordnete Massepotential und insbesondere Schutzleiterpotential sind notwendig. Für Versorgungsspannungen und zugeordnete Masse- und Schutzleiterpotentiale sind jedoch große Leiterquerschnitte erforderlich, wofür die Leiterbahnen der Leiterplatte ungeeignet sind. Dementsprechend verwendet man zur Verdrahtung höherer Potentiale beispielsweise Litzen oder Drähte zusätzlich zu den Leiterbahnen der Leiterplatte. Auch wenn entsprechende Potentiale auf der Leiterbahn an mehreren Stellen erforderlich sind, werden hierzu von den Leiterbahnen separate Leitungen benötigt, die im erforderlichen Umfang mit der Leiterplatte elektrisch verbunden sind, beispielsweise an diese angesteckt sind.

Es ist daher die Aufgabe der vorliegenden Erfindung, ein verbessertes Leitungskonzept für ein Leiterplattenmodul einer portablen elektrischen Maschine mit einer Leiterplatte der eingangs genannten Art bereitzustellen.

Zur Lösung der Aufgabe ist eine portable elektrische Maschine gemäß der technischen Lehre des Anspruchs 1 vorgesehen.

Zwischen dem mindestens einen Leitkörper und der Leiterplatte ist ein Zwischenkörper angeordnet und/oder an einer von der Leiterplatte abgewandten Seite des mindestens einen Leitkörpers ist ein weiterer Bodenkörper vorgesehen. Es versteht sich, dass nur der Zwischenkörper oder nur der Bodenkörper vorgesehen sein können. Bevorzugt ist jedoch die Ausgestaltung des Leiterplattenmoduls derart, dass sowohl der Zwischenkörper als auch der Bodenkörper vorhanden sind. Mindestens ein Leitkörper, zweckmäßigerweise alle Leitkörper der Leitkörperanordnung, verlaufen zweckmäßigerweise in einem Zwischenraum zwischen dem Zwischenkörper und dem Bodenkörper.

Zwar kann der Zwischenkörper prinzipiell eine beliebige geometrische Gestalt aufweisen. Bevorzugt ist jedoch eine plattenartige Gestalt, zumindest im Bereich unterhalb der Leiterplatte. Der Bodenkörper ist zweckmäßigerweise plattenförmig und/oder wannenartig.

Unterhalb der Leiterplatte verläuft mindestens ein Leitkörper-Verbindungsabschnitt, vor den der LeiterplattenKontaktvorsprung zur Durchdringung oder Eindringung in die Leiterplatte vorsteht. Der Leitkörper ist zumindest im Bereich des Leiterplatten-Kontaktvorsprungs und/oder des Leitkörper-Verbindungsabschnittes bezüglich einer Richtung biegesteif. Diese Richtung ist beispielsweise eine Einsteckrichtung zum Einstecken des Leiterplatten-Kontaktvorsprungs in die Kontaktöffnung der Leiterplatte. Dadurch wird die Montage vereinfacht.

Die Kontaktöffnung verläuft zweckmäßigerweise von einer zur anderen Flachseite.

Der Leitkörper ermöglicht einen größeren Leiterquerschnitt als die Leiterbahnen, so dass beispielsweise die Übertragung von Versorgungspotentialen, Massepotentialen und Schutzleiterpotentialen entlang der Leiterplatte vereinfacht ist. Vorzugsweise weist der Leitkörper einen größeren Leiterquerschnitt auf als jede der Leiterbahnen der Leiterplatte.

Selbstverständlich können mehrere Kontaktvorsprünge und/oder mehrere Kontaktöffnungen an der Leiterplatte vorgesehen sein.

Der Leitkörper dient vorzugsweise zum Anschluss einer elektrischen Versorgungsspannung und/oder eines Massepotentials und/oder eines Schutzleiterpotentials oder Erdungspotentials.

Der Leiterplatten-Kontaktvorsprung kann an einer isolierten Stelle die Leiterplatte durchdringen oder in diese eindringen. Es ist aber auch möglich, dass der LeiterplattenKontaktvorsprung mit der Leiterplatte elektrisch verbunden ist. In diesem Zusammenhang sei betont, dass insbesondere zur Herstellung eines elektrischen Kontaktes zwischen einerseits dem Leitkörper und andererseits der Leiterplatte beziehungsweise einer Leiterbahn derselben ein Eindringen des Kontaktvorsprunges ausreicht.

Bei einer bevorzugten Ausgestaltung der Erfindung durchdringt der Leiterplatten-Kontaktvorsprung die Kontaktöffnung und ist als Steckvorsprung zum Anstecken eines elektrischen Steckverbinders ausgestaltet. Der Steckvorsprung kann beispielsweise ein Einsteck-Steckvorsprung sein, der in einer entsprechenden Aufnahme des anzusteckenden Steckverbinders vorgesehen ist. Dieser ist zum Beispiel als eine Buchse ausgestaltet. Aber auch die umgekehrte Konfiguration kann getroffen sein, dass nämlich der Leiterplatten-Kontaktvorsprung als Steckaufnahme zur Aufnahme eines einen Steckvorsprung aufweisenden, an das Leiterplattenmodul anzuschließenden Steckverbinders aufweist.

Der mindestens eine Leitkörper weist zweckmäßigerweise einen Anschlussabschnitt auf, der zum elektrischen Anschluss einer weiteren Komponente, beispielsweise eines Steckverbinders, eines Kabels oder dergleichen, an mindestens einer Seite vor die Leiterplatte vorsteht. Zweckmäßigerweise sind zwei solche Anschlussabschnitte vorgesehen, die an verschiedenen Seiten, vorzugsweise an einander entgegengesetzten Seiten, jeweils vor die Leiterplatte vorstehen.

Der Leitkörper hat vorzugsweise eine Längsgestalt. Der oder die Anschlussabschnitte bilden dann entsprechend Längsenden des Leitkörpers. Es versteht sich, dass auch ein winkeliger oder gekrümmter Leitkörper im Sinne der Erfindung ist.

An dem Anschlussabschnitt ist zweckmäßigerweise mindestens ein Leitkörper-Steckanschluss, beispielsweise eine Steckaufnahme oder ein Steckvorsprung, für einen elektrischen Steckverbinder angeordnet. Der Steckvorsprung ist zweckmäßigerweise gleich ausgestaltet wie der Leiterplatten-Kontaktvorsprung. Mithin haben also zweckmäßigerweise sämtliche Steckvorsprünge oder Steckanschlüsse, die an dem mindestens einen Leitkörper angeordnet sind, die gleiche mechanische Ausgestaltung, insbesondere die gleiche geometrische Gestalt.

Die obige Maßnahme ist zwar zweckmäßig, jedoch nicht unbedingt notwendig für die nachfolgend beschriebene bevorzugte Ausgestaltung der Erfindung: Der mindestens eine LeitkörperSteckanschluss und/oder der Leiterplatten-Kontaktvorsprung bilden zweckmäßigerweise Bestandteile einer mehrpoligen Steckanschlussanordnung zum Anschluss eines mehrpoligen elektrischen Steckverbinders. Die Mehrpoligkeit kann beispielsweise dadurch realisiert werden, dass neben dem mindestens einen Leitkörper mindestens ein zweiter, vorzugsweise jedoch weitere, beispielsweise drei oder vier erfindunggemäße Leitkörper angeordnet sind, die entsprechende Leiterplatten-Kontaktvorsprünge beziehungsweise Leitkörper-Steckanschlüsse aufweisen, die zum Anschluss eines mehrpoligen elektrischen Steckverbinders geeignet sind.

Die Steckanschlussanordnung kann jedoch neben den Kontakten, die von einem oder mehreren erfindungsgemäßen Leitkörpern bereitgestellt werden, auch einen weiteren Kontakt aufweisen, der als ein Leiterplatten-Steckanschluss ausgestaltet ist. Dieser ist elektrisch ausschließlich mit der Leiterplatte verbunden und von dem Leitkörper elektrisch isoliert. Beispielsweise kann der weitere Leiterplatten-Steckanschlusses können auch mehrere vorgesehen sein - als eine Lötfahne oder Steckfahne ausgestaltet sein. Die geometrische Ausgestaltung des separaten Leiterplatten-Steckanschlusses entspricht vorzugsweise dem Leiterplatten-Kontaktvorsprung und/oder dem Leitkörper-Steckanschluss.

Der Bodenkörper und/oder der Zwischenkörper weisen eine Leitkörper-Aufnahme zur Aufnahme des mindestens einen Leitkörpers auf. Zweckmäßigerweise ist die Ausgestaltung so getroffen, dass sowohl der Bodenkörper als auch der Zwischenkörper Aufnahmen für den Leitkörper oder die Leitkörper aufweisen. Zweckmäßigerweise ist die Anordnung so getroffen, dass sich die Leitkörper-Aufnahmen des Bodenkörpers und des Zwischenkörpers in Längserstreckungsrichtung des mindestens einen Leitkörpers, den sie aufnehmen, hintereinander erstrecken. Aber auch ineinandergreifende Leitkörper-Aufnahmen am Bodenkörper und Zwischenkörper sind möglich, so dass diese insgesamt den Leitkörper halten und fixieren oder vorfixieren. Die vorgenannte Maßnahme sorgt dafür, dass der Leitkörper durch den Bodenkörper und/oder den Zwischenkörper gehalten wird, gegebenenfalls auch unabhängig von der Leiterplatte.

Zweckmäßigerweise stellen der Bodenkörper und/oder der Zwischenkörper auch eine Seitenbegrenzung für die Leiterplatte bereit. Beispielsweise kann an einem oder beiden der Körper an zumindest einer Seite eine Seitenwand oder Umfangswand vorgesehen sein, die die Leiterplatte seitlich begrenzt.

Eine bevorzugte Ausgestaltung der Erfindung sieht vor, dass der Zwischenkörper und/oder der Bodenkörper elektrisch isolierend sind. Beispielsweise besteht der jeweilige Körper zumindest teilweise aus Kunststoff und/oder hat eine elektrisch isolierende Beschichtung. Dadurch ist es beispielsweise möglich, dass der vorzugsweise elektrisch nicht isolierte Leitkörper elektrisch von der Umgebung, insbesondere der Leiterplatte, isoliert ist. Es versteht sich, dass auch der Leitkörper insbesondere abschnittsweise, beispielsweise an dem Leitkörper-Verbindungsabschnitt, elektrisch isoliert sein kann. Eine elektrische Isolierung des Zwischenkörpers und/oder des Bodenkörpers ist dann zwar vorteilhaft, jedoch nicht unbedingt notwendig.

An dem Zwischenkörper oder dem Bodenkörper oder der Leiterplatte ist vorteilhaft ein Isolationskörper, beispielsweiseals Bestandteil eines Steckverbindergehäuses, als eine Isolationswand, ein Isolationsvorsprung oder dergleichen, angeordnet, der zur elektrischen Isolation eines Steckanschlusses dient. Dieser Steckanschluss wird beispielsweise durch den Leitkörper bereitgestellt, zum Beispiel den Leiterplatten-Kontaktvorsprung oder den Steckanschluss am Anschlussabschnitt des Leitkörpers. Dadurch ist es beispielsweise möglich, elektrisch nicht isolierte Steckverbinder, beispielsweise an elektrische Kabel angecrimpte Steckbuchsen oder dergleichen, elektrisch isoliert und geschützt an das Leiterplattenmodul anzuschließen. Ein separates, in der Fertigung aufwendiges Steckergehäuse oder Isolationsmedium ist dann nicht erforderlich.

Es versteht sich, dass an dem Leiterplattenmodul, beispielsweise der Leiterplatte oder dergleichen, auch eine Steckerkodierung vorgesehen sein kann, die ein verpolungssicheres Einstecken des externen Steckverbinders gewährleistet. Beispielsweise kann das vorher erläuterte, bevorzugte Steckverbindergehäuse als eine Kodierung ausgestaltet sein. Aber auch ein sonstiger Isolationskörper, beispielsweise eine Isolationswand oder dergleichen, kann in Gestalt einer Kodierung ausgestaltet sein. Ferner ist es möglich, durch eine Beabstandung oder eine Anordnung der Steckanschlüsse, die durch beispielsweise den Leiterplatten-Kontaktvorsprung und/oder den Leitkörper-Steckanschluss am Anschlussabschnitt gebildet werden, eine Kodierung zu realisieren.

Zweckmäßigerweise ist ein zumindest teilweises Vergießen des Leiterplattenmoduls vorgesehen. Dieses weist zweckmäßigerweise eine Vergussschicht auf. Diese dient beispielsweise dazu, den Leitkörper an dem Leiterplattenmodul zu fixieren. Beispielsweise ist die Vergussschicht zwischen der Leiterplatte und dem Zwischenkörper und/oder zwischen dem Zwischenkörper und dem Bodenkörper angeordnet.

Zumindest ein Abschnitt des mindestens einen Leitkörpers, vorzugsweise aller Leitkörper der Leitkörperanordnung, sind zweckmäßigerweise in einem Wannenbereich des Bodenkörpers und/oder des Zwischenkörpers aufgenommen. Dieser Wannenbereich ist zweckmäßigerweise mit der oben erläuterten Vergussmasse zumindest teilweise verfüllt, was einen sicheren Halt der jeweiligen Komponenten aneinander realisiert. Auch der Zwischenkörper und die Leiterplatte sind zweckmäßigerweise in einem dann am Bodenkörper vorgesehenen Wannenbereich angeordnet. Es versteht sich, dass die Leiterplatte auch an einem Wannenbereich des Zwischenkörpers anordenbar ist.

Der Leitkörper hat zweckmäßigerweise eine Plattengestalt oder eine Flachgestalt. Eine Leitkörper-Flachseite des Leitkörpers verläuft zweckmäßigerweise quer, beispielsweise senkrecht, zur benachbarten Flachseite der Leiterplatte. Dadurch ist eine Biegesteifheit quer zur Flachseite der Leiterplatte realisiert.

Der Leiterplatten-Kontaktvorsprung und/oder der LeitkörperSteckanschluss stehen zweckmäßigerweise vor eine Schmalseite des mindestens einen Leitkörpers vor.

Ein spielarmes, jedoch einfaches Einstecken wird durch die nachfolgende Maßnahme realisiert: Die mindestens eine Kontaktöffnung verläuft bezüglich des Leiterplatten-Kontaktvorsprungs zumindest abschnittsweise schräg oder gebogen, insbesondere im Querschnitt, so dass der LeiterplattenKontaktvorsprung punktförmig, beispielsweise in einer Dreipunktlage oder Zweipunktlage, an einer Innenkontur der mindestens einen Kontaktöffnung anliegt. Die Kontaktöffnung hat beispielsweise eine sichelförmige, bananenförmige, im Wesentlichen dreikantartige oder dergleichen Innenkontur. Die Innenkontur ermöglicht zweckmäßigerweise eine Mehrpunktanlage, jedoch keine flächige Anlage, was das Einstecken des Kontaktvorsprungs in die Kontaktöffnung erleichtert.

Weiterhin ist es vorteilhaft, dass der mindestens eine Leitkörper eine oder mehrere mechanische Kodierungen aufweist. Beispielsweise hat der Leitkörper einen Kodiervorsprung, der in eine an der Leiterplatte, dem Zwischenkörper, dem Bodenkörper oder dergleichen vorgesehene Kodieraufnahme eingreift. Der Kodiervorsprung kann beispielsweise ein Kontaktvorsprung sein, der am geeigneten Montageplatz des Leitkörpers in eine korrespondierende Kodieraufnahme an der jeweils anderen Komponente des Leiterplattenmoduls eingreift. Es versteht sich, dass auch die umgekehrte Anordnung getroffen sein kann, dass nämlich der Leitkörper eine Kodieraufnahme aufweist, die zum Eingriff eines beispielsweise an der Leiterplatte, dem Zwischenkörper oder dem Bodenkörper vorgesehenen Kodiervorsprungs ausgestaltet ist. Weiterhin ist es vorteilhaft, wenn der Leitkörper eine Steckerkodierung zur polrichtigen Verbindung mit einem Steckverbinder aufweist, so dass eine Fehlkontaktierung oder ein Fehlanschluss des an das Leiterplattenmodul anzuschließenden Steckverbinders vermieden wird.

Vorzugsweise hat die Leitkörperahordnung mehrere, beispielsweise zwei oder mehr Leitkörper. Diese Leitkörper vorlaufen vorzugsweise parallel nebeneinander, wobei auch ein Querverlauf oder Schrägverlauf prinzipiell möglich ist.

Besonders bevorzugt ist die Erfindung in Zusammenhang mit portablen elektrischen Maschinen, beispielsweise Hand-Werkzeugmaschinen, Sauggeräten oder dergleichen.

Nachfolgend wird ein Ausführungsbeispiel der Erfindung anhand der Zeichnung erläutert. Es zeigen:
- Figur 1: eine perspektivische Frontal-Schrägansicht eines Sauggerätes,
- Figur 2: eine Querschnittsansicht des Sauggeräts gemäß Figur 1 etwa entlang einer Schnittlinie A-A in Figur 1,
- Figur 3: eine Draufsicht auf ein erfindungsgemäßes Leiterplattenmodul,

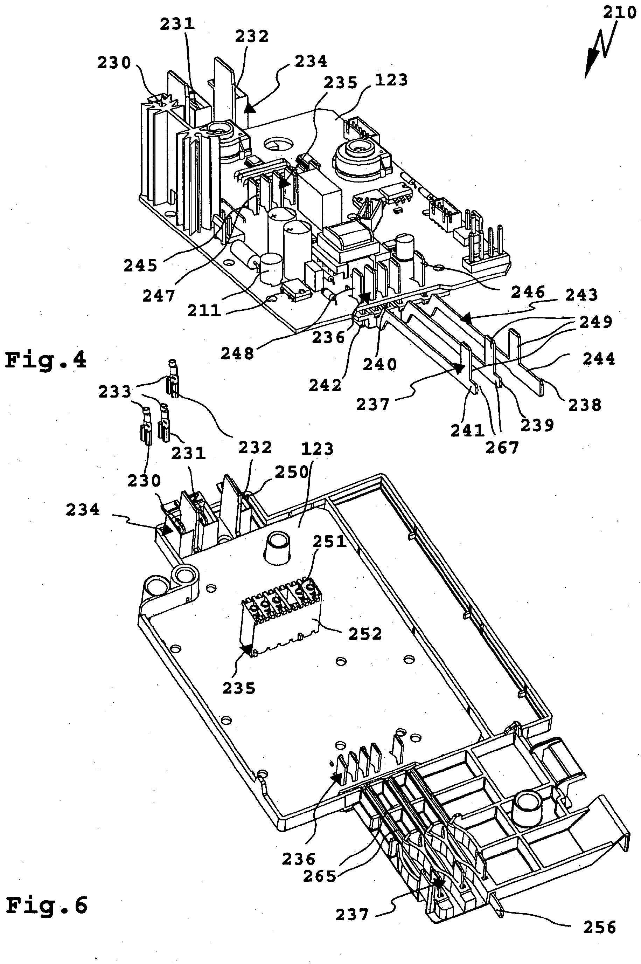

- Figur 4: eine perspektivische Schrägansicht des Leiterplattenmoduls gemäß Figur 3, jedoch ohne einen Bodenkörper,

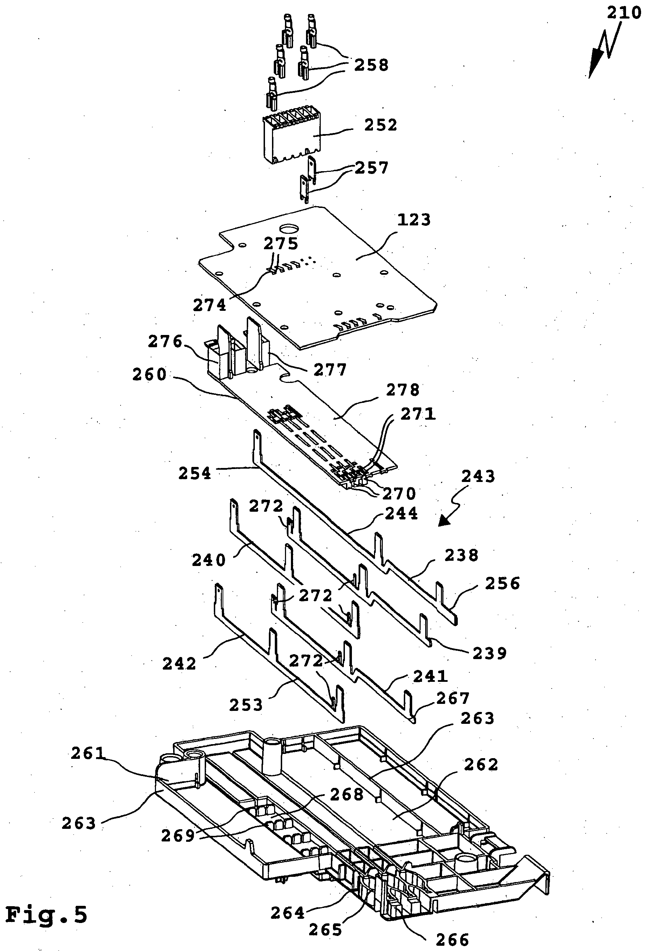

- Figur 5: eine Explosionsdarstellung des Leiterplattenmoduls gemäß Figur 3,
- Figur 6: das Leiterplattenmodul gemäß Figur 3 schräg von oben, allerdings ohne auf der Leiterplatte angeordnete elektrische Komponenten,
- Figur 7: eine Querschnittsansicht des Leiterplattenmoduls gemäß Figur 3 entlang einer Schnittlinie B-B,
- Figur 8: eine Querschnittsansicht des Leiterplattenmoduls gemäß Figur 3 entlang einer Schnittlinie C-C,
- Figur 9: ein Teilschaltbild einer Steuerungseinrichtung des Sauggeräts gemäß Figur 1 und
- Figur 10: eine Busnachricht, die auf einem Bus der Steuerungseinrichtung gemäß Figur 9 übertragen wird.

Im Inneren eines Saugergehäuses 11 eines Sauggeräts 10 ist ein Saugmotor 12 zum Erzeugen eines Saugstroms 13 angeordnet, der über einen Saugeinlass 14 in das Saugergehäuse 11 einsaugbar ist. An den Saugeinlass 14 ist ein nicht dargestellter Schlauch anschließbar. Im Inneren des Saugergehäuses 11 befindet sich ferner eine Filteranordnung 15 zum Absondern von Partikeln aus dem Saugstrom 13.

An einer Oberseite 16 des Saugergehäuses 11 befindet sich eine Aufnahme 17 zur Aufnahme des Saugschlauches und/oder eines Anschlusskabels 18, mit dem das Sauggerät 10 an ein elektrisches Versorgungsnetz mit z.B. 110 Volt oder 230 Volt Wechselstrom anschließbar ist. Alternativ wäre ein Sauggerät mit einem Akkumulator möglich. Das Sauggerät 10 ist ein transportables Sauggerät, an dessen Unterseite Fahrrollen 19, 20 angeordnet sind. Die vorderen Fahrrollen 20 sind Lenkrollen. Weiterhin kann das Sauggerät 10 an einem Tragegriff 21 an der Oberseite 16 ergriffen werden.

Zwischen einer den Saugeinlass 14 aufweisenden Frontwand 22 und der Oberseite 16 des Saugergehäuses 11 erstreckt sich eine Bedienwand 23 mit Bedienelementen 24 zur Bedienung des Sauggeräts 10. Die Bedienwand 23 ist zweckmäßigerweise schräg geneigt, so dass die Bedienelemente 24 von schräg oben vorn leicht bedienbar sind.

Die Bedienelemente 24 umfassen einen Schalter 25, der sozusagen einen Hauptschalter bildet. Mit dem Schalter 25 kann der Saugmotor 12 ein- und ausgeschaltet werden. Ferner ist ein Automatikmodus einstellbar, bei dem der Saugmotor 12 immer dann läuft, wenn ein angeschlossener Verbraucher elektrischen Strom über das Sauggerät 10 erhält, was später noch erläutert wird. Mit Hilfe eines Saugleistungs- oder Drehzahlschalters 26 kann eine Leistung des Saugmotors 12 eingestellt werden. Ein Anpassungsschalter 27 ermöglicht eine elektrische Anpassung des Sauggeräts 10 an einem jeweiligen Saugeinlass 14 angeschlossenen Saugschlauch. Mit einem Reinigungsschalter 28 ist eine Reinigungsfunktion des Sauggeräts 10 einschaltbar und/oder parametrierbar. Eine fest am Sauggerät 10 installierte Steckdose 29 ermöglicht das Einstecken eines elektrischen Energieverbrauchers. Die Steckdose 29 ist mit dem Anschlusskabel 18 elektrisch verbunden.

In einem unteren Teil, einem Sammelgehäuseteil 31, des Saugergehäuses 11 ist ein dem Innenraum 47 oder Sammelraum 110 zum Sammeln von aus dem Saugstrom 13 abgesonderten Partikeln und/oder abgesonderter Feuchtigkeit vorgesehen, in dem optional ein großformatiger Filtersack 48 der Filteranordnung 15 anordenbar ist. Einem zum Saugmotor 12 führenden Saugeinlass 56 ist ein Hauptfilter 61 vorgelagert.

Der Saugstrom 13 wird durch den Saugeinlass 14, an dem ein Saugschlauch 190 anordenbar ist, in den Filtersack 48 eingesaugt. Der Filtersack 48 nimmt im Saugstrom 13 enthaltene Partikel 180 auf. Der Saugstrom 13 wird vom Saugmotor 12 erzeugt, der den Saugstrom 13 über den Hauptfilter 61 durch den Saugeinlass 56 hindurch ansaugt. Der Saugeinlass 56 ist strömungsabseitig, beim Sauggerät 10 oberseitig, des Hauptfilters 61 angeordnet. Der Saugeinlass 56 ist mit einem Turbineneinlass 70 einer Saugturbine 71 eines den Saugmotor 12 enthaltenden Motormoduls 58 über eine Luftführungsanordnung 55 verbunden. Die Saugturbine 71 saugt den Saugstrom 13 durch den Turbineneinlass 70 an und bläst ihn nach radial außen über Schalldämpfer 84, die zugleich optional eine Filterfunktion haben können, hindurch und sodann durch Saugstromauslässe 85 an den Seitenwänden des Saugergehäuses 11 nach außen aus dem Saugergehäuse 11 hinaus.

Ein Kühlluftstrom 94 strömt durch einen Kühllufteinlass 96 an der Frontwand 22 des Saugergehäuses 11 ein. Der Kühlluftstrom 94 strömt zunächst an einer Steuerungseinrichtung 97 des Sauggeräts 10 vorbei und kühlt diese. Über einen zwischen dem Hauptfilter 61 und einer Deckwand 52 des Saugergehäuses 11 verlaufenden Kühlluftkanal 98 strömt der Kühlluftström 94 weiter zu einem Motoraufnahmeraum 54 für den Saugmotor 12, in dem der Kühlluftstrom 94 von oben her in einen Kühllufteinlass des Saugmotors 12 einströmt. Der Kühlluftstrom 94 durchströmt den Saugmotor 12 und strömt sodann nach hinten durch einen Kühlluftauslass 99 aus dem Saugergehäuse 11 aus, an dem zweckmäßigerweise ein Schalldämpfer 100 vorgesehen ist.

An einem Saugrohranschluss 133, an den der Säugschlauch 190 anschließbar ist, ist ein Erdungskontakt 137 vorgesehen. Der Erdungskontakt 137 ist als ein Federkontakt, beispielsweise eine Federzunge, ausgestaltet. Der Saugrohranschluss 133, z.B. eine Rohrmuffe, und/oder der Saugschlauch 190 bestehen zweckmäßigerweise aus einem elektrisch leitfähigen Material, insbesondere Kunststoff, insbesondere in einem für den Erdungskontakt 137 vorgesehenen Berührbereich.

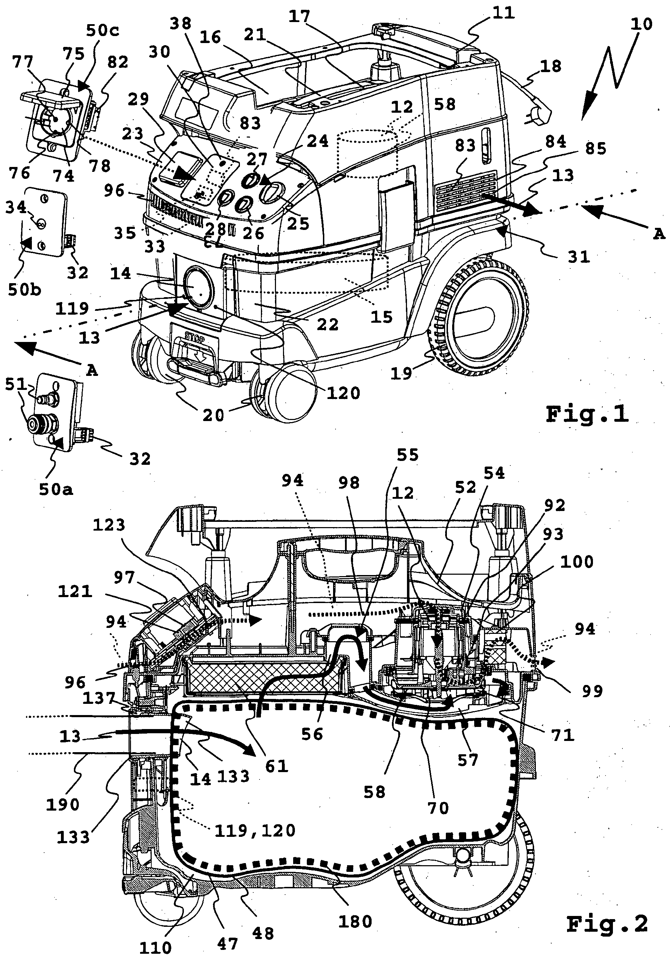

Ein Sensor 121 detektiert einen Füllstand einer Flüssigkeit oder einer sonstigen elektrisch leitfähigen Substanz in dem Sammelraum 110 und generiert in Abhängigkeit davon ein Sensorsignal. Der Sensor 121 ist vorzugsweise auf einer Leiterplatte 123 der Steuerungseinrichtung 97 angeordnet. Von einer Außenseite des Saugergehäuses 11 elektrisch abtastbare (siehe Figur 1) Erfassungsteile 119, 120 des Sensors 121 stehen in den Sammelraum 110, mithin also in Innenraum 47 des Sammelgehäuseteils 31, vor. Signalverbindungen zwischen den Erfassungsteilen 119, 120 außerhalb des Sammelraums 110, jedoch elektrisch geschützt und verdeckt am Saugergehäuse 11.

Die Steuerungseinrichtung 97 ist mit den Bedienelementen 24 beeinflussbar. Zweckmäßigerweise ist die Leiterplatte 123 unterhalb der Bedienelemente 24 angeordnet, d.h. unterhalb der Bedienwand 23. Die Steuerungseinrichtung 97 ist mit dem Saugmotor 12, insbesondere dem Motormodul 58 über nicht dargestellte elektrische Leitungen verbunden und steuert diesen.

An der Bedienwand 23 ist eine zweckmäßigerweise in der Art eines Aufnahmeschachtes ausgestaltete, in Figur 1 mit einer Abdeckplatte 38 abgedeckte Modulaufnahme 30 zur wahlweisen Aufnahme von Funktionsmodulen 50a-50c vorgesehen, die elektrische, optische und akustische Funktionen bereitstellen.

Das Funktionsmodul 50a ist z.B. ein Druckluft-Modul zum Anschließen eines Druckluft-Werkzeuges. Das Funktionsmodul 50a hat eine Druckluft-Anschlussanordnung 51 mit DruckluftAnschlüssen, an die jeweils ein Druckluftschlauch anschließbar ist. Somit kann also eine Druckluftverbindung über die Anschlussanordnung 51 durch das Funktionsmodul 50a durchgeschleift werden, wobei ein Druckluftpfad im Funktionsmodul 50a über einen Druckluftsensor zum Erfassen eines Druckluftstromes führt. Der Druckluftsensor ist über Modulsignalkontakte 32 mit Sauggerät-Signalkontakten 33 elektrisch verbunden, wenn das Funktionsmodul 50a in die Modulaufnahme 30 eingesteckt ist.

Das Funktionsmodul 50b weist einen Bus-Anschluss 34 mit einem Buskontakt 35 zum Anschluss an einen Datenbus 36 des Sauggeräts 10 auf. Ein Buskontakt 35 der Sauggerät-Signalkontakte 33 ist mit dem Funktionsmodul 50b verbindbar.

Das Funktionsmodul 50c weist z.B. einen elektrischen Stromversorgungsanschluss 73 zum Anschluss eines elektrischen Verbrauchers, beispielsweise eines Elektro-Werkzeugs, auf. Der Stromversorgungsanschluss 73 umfasst eine Steckdose 74, vorzugsweise eine Schutzkontaktsteckdose, die mittels eines Deckels 75 verschließbar ist. Kontakte 76, 77 und 78 der Steckdose 74 sind über Leitungen mit Kontakten eines Steckverbinders 82 verbunden. Der Steckverbinder 82 dient zur Herstellung elektrischer Verbindungen zu Versorgungskontakten 83 im Innern der Modulaufnahme 30 des Sauggeräts 10, die z.B. für eine Schutzleiterverbindung, eine Masseverbindung und eine Dauerstrom-Verbindung vorgesehen sind.

Die Steuerungseinrichtung 97, insbesondere die Anordnung der Leiterplatte 123, sowie das damit in Beziehung stehende elektrische Anschlusskonzept, unter anderem zum Ansehluss der Funktionsmodule 50a, 50b oder 50c, sind bei dem Säuggerät 10 innovativ und auf erfindungsgemäße Weise gelöst:
Die Leiterplatte 123 bildet einen Bestandteil eines Leiterplattenmoduls 210, auf der elektrische Komponenten 211, beispielsweise ein erster und ein zweiter Mikroprozessor 212, 213, die zweckmäßigerweise über Optokoppler 214, 215 oder sonstige galvanisch trennende Komponenten miteinander kommunizieren, Leistungshalbleiter zur Ansteuerung beispielsweise des Saugmotors 12, zum Beispiel ein Triac 216, an einem Kühlkörper 217 sowie weitere, hier nicht im Detail beschriebene Komponenten, beispielsweise Widerstände, Kondensatoren und dergleichen, angeordnet sind. Die elektrischen Komponenten 211 sind auf einer oberen Flachseite 218 angeordnet. An der Flachseite 218 sowie einer dieser gegenüberliegenden unteren Flachseite 219 der Leiterplatte 123 verlaufen schematisch angedeutete Leiterbahnen 220 zur Verbindung der elektrischen Komponenten 211. Weiterhin sind die Bedienelemente 24 elektrisch und/oder mechanisch mit der Steuerungseinrichtung 97 verbunden. Beispielsweise sind Steuerglieder 221, 222 vorgesehen, zum Beispiel Potentiometer, die beispielsweise mit dem Saugleistungsschalter 26, dem Anpassungsschalter 27 sowie dem Reinigungsschalter 28 mechanisch verbunden sind. Somit kann beispielsweise eine Saugleistung des Saugmotors 12, eine Betriebsart oder dergleichen an der Steuerungseinrichtung 97 vorgewählt werden.

Zur elektrischen Verbindung von Sensoren oder Sensorflächen, zum Beispiel der Erfassungsteile 119, 120, sind an der Leiterplatte 123 Sensoranschlüsse 223 vorgesehen, beispielsweise Pfostenstecker.

Die Sauggerät-Signalkontakte 33 sind mit Leiterplatten-Signalkontakten 224 elektrisch verbunden. Signalanschlüsse 225 dienen zum Anschluss weiterer Sensoren, beispielsweise eines Temperatursensors für den Saugmotor 12, eines Strömungs- oder Drucksensors für den Saugstrom 13 oder dergleichen.

Der erste Mikroprozessor 212 befindet sich auf einem ersten Potentialbereich 226 der Leiterplatte 123 und ist mit den dort befindlichen Komponenten 211 vernetzt, während der zweite Mikroprozessor 213 in einem zweiten Potentialbereich 227 angeordnet ist und mit den dortigen Komponenten 211 verbunden ist, beispielsweise mit den Sensoranschlüssen 223 oder den Signalkontakt-Anschlüssen 224, 225. Der erste Potentialbereich 226 ist mit einem Netzpotential, das über das Anschlusskabel 18 kommt, verbunden, während der zweite Potentialbereich 227 ein im Vergleich zum Potentialbereich 226 niedrigeres elektrisches Potential aufweist, beispielsweise in Höhe von Signalspannungen von 5 bis 12 Volt oder dergleichen. Somit ist ein Berührkontakt seitens eines Bedieners bezüglich des zweiten Potentialbereichs 227 möglich, was zum Beispiel im Bereich der Erfassungsteile 119 oder 120 nicht auszuschließen ist. Durch die Optokoppler 214, 215 ist eine Potentialtrennung zwischen den beiden Potentialbereichen 226, 227 realisiert, so dass der Bediener mit dem im Potentialbereich 226 vorhandenen höheren elektrischen Potential nicht in Berührung kommt.

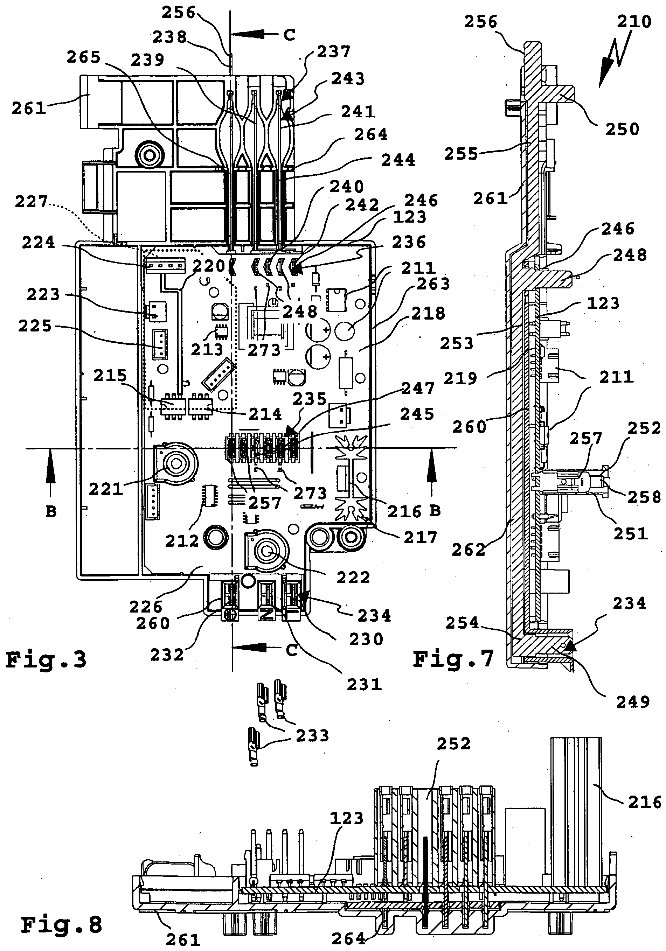

In Figur 3 ist der zweite Potentialbereich 227 in gestrichelten Linien angedeutet. Der übrige Bereich der Leiterplatte 123 ist dem ersten Potentialbereich 226 zugeordnet.

Nicht nur im Hinblick auf eine optimierte Potentialtrennung auf der Leiterplatte 123 ist die elektrische Beschaltung und Verdrahtung bei dem Sauggerät 10, insbesondere dessen Steuerungseinrichtung 97, optimal, sondern auch im Hinblick auf das übrige Verdrahtungs- und Anschlusskonzept.

Über das Anschlusskabel 18 kommen beispielsweise ein Netzpotential 230, ein Massepotential 231 sowie ein Schützleiterpotential 232, die über eine nicht dargestellte Verbindungsleitung sowie über Steckverbinder 233 an eine Steckanschlussanordnung 234 des Leiterplattenmoduls 210 angeschlossen sind. Die Steckanschlussanordnung 234 ist elektrisch mit weiteren mehrpoligen Steckanschlussanordnungen 235 zum elektrischen Anschluss des Schalters 25 des Hauptschalters, zum elektrischen Anschluss des Funktionsmoduls 50c sowie einer Steckanschlussanordnung 237 zur Verbindung mit der Steckdose 29 verbunden. Dazu sind Leitkörper 238-242 einer Leitkörperanordnung 243 vorgesehen, die an der unteren Flachseite 219 der Leiterplatte 123 entlang verlaufen. Die Leitkörper 238-242 haben eine Flachgestalt. Ihre Schmalseiten 244 sind der unteren Flachseite 219 zugewandt.

An den Schmalseiten 244 stehen bei den Leitkörpern 238-242 Kontaktvorsprünge vor, nämlich die Leiterplatte 123 an Kontaktöffnungen 245, 246 durchdringende Leiterplatten-Kontaktvorsprünge 247, 248, die Bestandteile der Steckanschlussanordnungen 235, 236 bilden, sowie Leitkörper-Steckanschlüsse 249, 250, die Bestandteile der Steckanschlussanordnungen 234, 237 bilden.

Die die Leiterplatte 123 durchdringenden LeiterplattenKontaktvorsprünge 247, 248 sowie die Leitkörper-Steckanschlüsse 249, 250 sind als Steckvorsprünge ausgestaltet, die jeweils vor die obere Flachseite 218 der Leiterplatte 123 vorstehen. Dort stehen sie zur Kontaktierung durch einen jeweiligen, insbesondere mehrpoligen Steckverbinder bereit, beispielsweise einen mehrpoligen Steckverbinder 251, der auf die Steckanschlussanordnung 235 aufgesteckt ist. Der Steckverbinder 251 weist in seinem Inneren mehrere den Steckverbinder 233 entsprechende Anschlussbuchsen oder Steckanschlüsse 257 auf, die vorzugsweise in einem Steckergehäuse 252 angeordnet sind. Die Leiterplatten-Kontaktvorsprünge 247, 248 stehen nach oben vor Leitkörper-Verbindungsabschnitte 253 der Leitkörper 238-242 vor, die entlang der unteren Flachseite 219 der Leiterplatte 123 verlaufen. Vor die Leiterplatte 123 stehen Anschlussabschnitte 254, 255 der Leitkörper 238-242 vor, an denen die Steckanschlüsse 249, 250 vorgesehen sind. Die Steckanschlüsse 249, 250 stehen zur selben Seite wie die Kontaktvorsprünge 247, 248 vor, wobei es durchaus möglich ist, dass Kontaktvorsprünge und/oder Steckanschlüsse bei erfindungsgemäß verwendeten Leitkörpern an unterschiedlichen Seiten, insbesondere entgegengesetzte Seiten, vorstehen. So steht beispielsweise beim Leitkörper 238 ein Steckanschluss 256 in dessen Längserstreckungsrichtung nach vorn vor, das heißt quer zu den Leitkörper-Steckanschlüssen 250. Der Steckanschluss 256 dient zum Anschluss einer Steckverbinderbuchse in der Art der Steckverbinder 233, um eine elektrische Verbindung zu dem Erdungskontakt 137 am Saugrohranschluss 133 herzustellen.

Sämtliche elektrischen Kontakte der Steckanschlussanordnungen 234, 236, 237 sind durch Kontaktvorsprünge der Leitkörperanordnung 243 realisiert. Bei der Steckanschlussanordnung 235, die für das Funktionsmodul 50c vorgesehen ist, sind noch zwei weitere elektrische Steckverbinder beziehungsweise elektrische Steckanschlüsse 257 vorhanden, die ausschließlich in elektrischer Verbindung mit der Leiterplatte 123 stehen.

Durch wahlweise Bestückung von Aufnahmekammern des Steckergehäuses 252 mit Steckbuchsen 258 und an diese jeweils angeschlossene elektrische Leitungen ist es beispielsweise möglich, unterschiedliche Verdrahtungsvarianten zu realisieren, ohne Modifikationen am Leiterplattenmodul 210 vorzunehmen. Eine solche Vorgehensweise ist selbstverständlich auch bezüglich der anderen Steckanschlussanordnungen 234, 236, 237 möglich, an die je nach Bedarf, beispielsweise für unterschiedliche Ländervarianten, unterschiedliche Anschlussleitungen beziehungsweise Steckverbinder angeschlossen werden können. Die beiden Steckanschlüsse 257, die ausschließlich mit der Leiterplatte 123 verbunden sind, ermöglichen beispielsweise eine Erfassung eines über die Steckdose 74 fließenden Stromes, so dass die Steuerungseinrichtung 97 den Saugmotor 12 bei fließendem Strom, das heißt bei einem an das Sauggerät 10 angeschlossenen, laufenden elektrischen Gerät, den Saugmotor 12 einschaltet. Ferner ist es möglich, dass die Steckdose 74 schaltbar ausgestaltet ist, so dass sie beispielsweise nur dann Strom liefert, wenn der Schalter 25 in Betriebsstellung geschaltet ist.

Die Leitkörper 238-242 haben Leiterquerschnitte, die größer sind als die Leiterquerschnitte der Leiterbahnen 220, so dass sie größere Ströme leiten können. Dies ist insbesondere im Hinblick auf den Leitkörper 238, der das Schutzleiterpotential 232 leitet, wesentlich. Der Leitkörper 238 hat keinen elektrischen Kontakt zu der Leiterplatte 123 beziehungsweise den darauf angeordneten Leiterbahnen 220 oder elektrischen Komponenten 211. Der Leitkörper 238 durchdringt die Leiterplatte 123 lediglich im Bereich der Steckanschlussanordnung 236 mit einem Leitkörper-Kontaktvorsprung 248. Unterhalb der etwa im Bereich einer Längsmitte der Leiterplatte 123 angeordneten Steckanschlussanordnung 235 ist jedoch kein elektrischer Kontakt zur Leiterplatte 123 und insbesondere nicht zur Steckanschlussanordnung 235 vorhanden. Dies ist durch das erfindungsgemäße Konzept möglich.

Allein schon durch einen Isolationsabstand zwischen der unteren Flachsseite 219 und dem Leitkörper 238 ist eine elektrische Isolation, insbesondere im Bereich der Steckanschlussanordnung 235, realisiert. Zudem ist noch zwischen der Leiterplatte 123 und der Leitkörperanordnung 243 ein im Wesentlichen plattenartiger Zwischenkörper 260 angeordnet, der zweckmäßigerweise elektrisch isolierend ist. Der Zwischenkörper 260 besteht beispielsweise aus Kunststoffmaterial und erstreckt sich zumindest im Bereich der Leitkörperanordnung 243 unterhalb der Leiterplatte 123. Unterhalb des Zwischenkörpers 260 ist sozusagen als Boden oder Basis ein Bodenkörper 261 angeordnet. Die Leiterplatte 123, der Zwischenkörper 260, die Leitkörperanordnung 243 sowie schließlich der Bodenkörper 261 bilden die wesentlichen Komponenten des Leiterplattenmoduls 210. Diese Komponenten sind zweckmäßigerweise insgesamt vergossen, was sowohl in mechanischer Hinsicht als auch in elektrisch isolierender Hinsicht vorteilhaft ist.

Die Leiterplatte 123, der Zwischenkörper 260 sowie die darunter verlaufenden Leitkörper-Verbindungsabschnitte 253 der Leitkörper 238-242 sind in einer Wanne oder einem Wannenbereich 262 des Bodenkörpers 261 aufgenommen. Entlang der Schmalseiten der Leiterplatte 123 erstreckt sich eine Umfangswand 263 des Bodenkörpers 261. Insbesondere der Wannenbereich 262 eignet sich zu einer Verfüllung mit einer Vergussmasse, was das Leiterplattenmodul 210 mechanisch stabilisiert und elektrisch isoliert.

Bezüglich der Längserstreckungsrichtung der Leitkörper 238-242 ist neben dem Wannenbereich 262 ein Anschlussbereich 264 des Basis- oder Bodenkörpers 261 angeordnet, der mit dem Wannenbereich 262 einstückig ist und die Anschlussabschnitte 255 der Leitkörper 238, 239 und 241 aufnimmt. Für diese sind. Leitkörper-Aufnahmen 265 vorgesehen. Die Leitkörper 238, 239, 241 liegen mit ihren Flachseiten an Innenwänden der Leitkörper-Aufnahmen 265 im Wesentlichen flächig an, so dass sie einen festen Halt haben. Zudem haben die Leitkörper-Aufnahmen 265 Steckaufnahmen 266 an ihren vom Wannenbereich 262 abgewandten Endbereichen, in die Steckenden 267 der Leitkörper 239, 241 einsteckbar beziehungsweise der Steckanschluss 256 durchsteckbar ist. Der Steckanschluss 256 steht nach vorn vor eine Stirnwand des Leiterplattenmoduls 210 vor.

Die Leitkörper-Aufnahmen 265 erstrecken sich auch in den Wannenbereich 262 hinein. Die dem Leitkörper 238 zugeordnete Leitkörper-Aufnahme 265 verläuft abseits der LeitkörperAufnahmen 265 für die Leitkörper 239-242 und ist in der Art einer Aufnahmenut realisiert. Somit ist eine optimale elektrische Isolation des Schutzleiterpotentials 232 realisiert.

Die Leitkörper-Aufnahmen 265 für die Leitkörper 239-242 haben einen gemeinsamen, muldenartigen Aufnahmebereich 268. In dem Aufnahmebereich 268 des Bodenkörpers 261 verlaufen die Leitkörper-Verbindungsabschnitte der Leitkörper 239-242 parallel nebeneinander, sind jedoch durch Trennstege 269 voneinander getrennt. Bezüglich einer Längserstreckungsrichtung der Leitkörper 239-242 sind mehrere Trennstege 269 vorgesehen, die jeweils einen Aufnahmeschlitz oder eine Aufnahmenut für den jeweiligen Leitkörper 239-242 aufweisen.

Zwischen die Trennstege 269 passen jeweils in Längserstreckungsrichtung der Leitkörper 238-242 hintereinander angeordnete Gruppen von Haltevorsprüngen 270 am Zwischenkörper 260. Zwischen jeweils zwei quer zur Längserstreckungsrichtung der Leitkörper angeordneten Haltevorsprüngen 270 ist eine Leitkörper-Aufnahme 271 für den jeweiligen Leitkörper 239-242 gebildet.

Die Haltevorsprünge 270 passen also komplementär zwischen die Trennstege 269 des Aufnahmebereichs 268, was einen optimalen Halt der Leitkörper 239-242 zwischen dem Bodenkörper 261 und dem Zwischenkörper 260 ermöglicht.

Es versteht sich, dass der Zwischenkörper 260 Durchbrüche oder Öffnungen zum Durchstecken der Leiterplatten-Kontaktvorsprünge 247, 248 aufweist.

Eine fehlerfreie Montage der Leitkörper 238-242 am Leiterplattenmodul 210 wird beispielsweise durch eine geometrische Ausgestaltung, die für die Leitkörper 238-242 individuell sein kann, realisiert. Dadurch ist eine Art mechanische Kodierung, die zur fehlerfreien Montage beiträgt, vorhanden. Hierbei ist festzuhalten, dass beispielsweise die Leitkörper 240, 242 und 239, 241 jeweils konturgleich sind, was die Teilevielfalt reduziert.

Zudem sind mechanische Kodierungen 272, beispielsweise Vorsprünge, vorgesehen, die zum Eingriff in korrespondierende Kodieraufnahmen 273 an der Leiterplatte 123 vorgesehen sind.

Die geometrische Ausgestaltung der Leitkörper-Aufnahmen 265, 271 sowie die Kodierungen 272 und die Kodieraufnahmen 273 erlauben somit eine polrichtige und insbesondere fehlerfreie Montage der Leitkörper 238-242 am Leiterplattenmodul 210. Trotz der dadurch bedingten geringen mechanischen Spielräume bei der Montage ist es möglich, die LeiterplattenKontaktvorsprünge 247, 248 mit geringem Aufwand in die Kontaktöffnungen 245, 246 einzustecken, wo sie mit geringem Spiel aufgenommen sind. Die Kontaktöffnungen 245, 246 haben eine im Wesentlichen dreieckförmige Gestalt. Ein den Schrägseiten 275 gegenüberliegender Vorsprung 274 der Kontaktöffnungen 245, 246 liegt an einer Flachseite eines jeweiligen Leiterplatten-Kontaktvorsprungs 247, 248 an, während Randbereiche der entgegengesetzten Flachseite der Kontaktvorsprünge 247, 248 punktförmig oder linienförmig an den Schrägseiten 275 anliegen.

Die Steckanschlüsse 249 der Steckanschlussanordnung 234 sind von Isolationskörpern 276 umgeben, die insgesamt ein Steckverbindergehäuse 277 bilden. Die Steckanschlüsse 249 sind durch die Isolationskörper 276 eingehaust, so dass sie elektrisch isoliert sind. Die Isolationskörper 276 beziehungsweise das Steckverbindergehäuse 277 ist einstückig an den Zwischenkörper 260 angeformt und stehen nach oben vor einen Plattenabschnitt 278 des Zwischenkörpers 260 vor. Das Steckverbindergehäuse 277 steht auch nach oben vor die obere Flachseite 218 der Leiterplatte 123 vor.

Der Mikroprozessor 212 und der Mikroprozessor 213 kommunizieren über den Datenbus 36 miteinander. Dadurch ist die Anzahl erforderlicher Leitungen zwischen den galvanisch getrennten Potentialbereichen 226, 227 gering. Dem ersten Potentialbereich 226 ist ein Primärbusabschnitt 281 des Datenbusses 36 zugeordnet, während auf dem zweiten Potentialbereich 227 ein Sekundärbusabschnitt 282 des Datenbusses 36 verläuft. Die Busabschnitte 281, 282 sind durch Übertragungsmittel 280 miteinander gekoppelt. Die Übertragungsmittel 280 realisieren eine galvanische Trennung. Die beiden Optokoppler 214, 215 bilden eine erste und eine zweite Übertragungseinrichthng 283, 284 zur Übertragung von Busdaten vom Primärbusabschnitt 281 auf den Sekundärbusabschnitt 282 und umgekehrt. Die Optokoppler 214, 215 bewirken eine galvanische Trennung des Datenbusses 36 in die beiden Busabschnitte 281, 282. Es versteht sich, dass anstelle eines öder beider Optokoppler 214, 215 auch ein magnetischer Übertrager möglich ist.

Die beiden Mikroprozessoren 212, 213 haben unterschiedliche Aufgaben. Der erste Mikroprozessor 212 steuert beispielsweise den Leistungshalbleiter oder Triac 216 an, beispielsweise über einen Steuerausgang 285. Der Mikroprozessor 212 hat weitere Eingänge und Ausgänge 286, beispielsweise für eine Drehzahlüberwachung des Saugmotors, eine Spannungssynchronisation, zur Ansteuerung eines akustischen Signalmittels oder dergleichen. Weitere Ein- und Ausgänge sind zum unmittelbaren Anschluss an den Primärbusabschnitt 281 des Datenbusses 36 vorgesehen, nämlich ein Busausgang 287 und ein Buseingang 288. Somit ist der Datenbus 36 unmittelbar auf den Mikroprozessor 212 aufgelegt, der die Buskommunikation direkt bewältigt. Eine zusätzliche Kommunikationseinrichtung ist nicht notwendig. Der Mikroprozessor 212 bildet eine erste Kommunikationseinrichtung 289.

Auch der zweite Mikroprozessor 213 bildet unmittelbar eine Kommunikationseinrichtung, nämlich eine zweite Kommunikationseinrichtung 290, die an den Sekundärbusabschnitt 282 und somit an den Datenbus 36 angeschlossen ist. Der zweite Mikroprozessor 213 weist neben Ein- und Ausgängen 291, die zum Beispiel zum Anschluss der Erfassungsteile 119, 120, zum Anschluss eines Temperatursensors, zum Anschluss eines Sensors in einem der Funktionsmodule 50a-50c oder dergleichen, vorgesehen sind, einen Busein-/-ausgang 292 auf, der mit dem Sekundärbusabschnitt 282 verbunden ist. Der Busein-/-ausgang 292 ist für eine bidirektionale Kommunikation ausgestaltet, das heißt, der Mikroprozessor 213 empfängt und sendet Daten auf einem einzigen Busein-/-ausgang 292. Der Sekundärbusabschnitt 282 ist als ein Eindrahtbus ausgestaltet, der nur eine einzige Busleitung 293 aufweist.

Die Busleitung 293, die zur bidirektionalen Kommunikation vorgesehen ist, ist über einen oder mehrere Pull-up-Widerstände 294 mit einem oberen Potentialniveau, beispielsweise 5 Volt, verbunden. Korrespondierend dazu ist eine mit dem Busausgang 287 verbundene Busleitung 295 über einen Pullup-Widerstand 297 und eine mit dem Buseingang 288 über einen Widerstand 299 verbundene Busleitung 296 über einen Pull-up-Widerstand 298 mit einem Massepotential verbunden. Die Busleitung 295 ist mit einem Sendeeingang des Optokopplers 214 verbunden, die Busleitung 296 mit einem zur Übertragung empfangener Daten vorgesehenen Ausgang des Optokoppler 215. Dadurch, dass die beiden Kommunikationseinrichtungen 289, 290 mit voneinander separaten Busanschlüssen 287, 288 des Mikroprozessors 212 beziehungsweise der Kommunikationseinrichtung 289 verbunden sind, wird eine Rückkopplung vermieden.

Auf der Seite des Sekundärbusabschnittes 282 ist dies nicht erforderlich. Allerdings ist dort am Eingang der zweiten Kommunikationseinrichtung, das heißt des Optokopplers 215, eine Verstärkerschaltung 300 mit einem Transistor 301 vorgesehen. Es versteht sich, dass die Verstärkerschaltung 300 nur exemplarisch zu verstehen ist und auch anders realisiert werden kann oder auch ganz entfallen kann, beispielsweise wenn eingangsseitig an der zweiten Kommunikationseinrichtung 290 eine geringere Spannung ausreichend ist.

Die Ausgestaltung des Sekundärbusabschnittes 282 als echten Eindrahtbus, bei dem eine einzige Busleitung 293 ausreichend ist, ermöglicht den einfachen Anschluss weiterer Kommunikationseinrichtungen, die beispielsweise Bestandteil des Säuggerätes 10 bilden können oder - in einer bevorzugten Ausgestaltung der Erfindung - auch als separate Baueinheiten ausgestaltet sein können. So ist beispielsweise der Buskontakt 35 über eine Schutzbeschaltung 302 unmittelbar mit dem Sekundärbusabschnitt 282, somit also mit dem Datenbus 36 verbunden. Der Buskontakt 35 bildet daher eine Schnittstelle 303 zum Anschluss einer von der Maschine 10 separaten Kommunikationseinrichtung 304, beispielsweise eines Diagnose-Computers, einer Anzeigeeinrichtung oder dergleichen. Somit kann beispielsweise ein Funktionsmodul realisiert sein, das unmittelbar an den Datenbüs 36 angekoppelt ist. Ein solches Funktionsmodul, das im Wesentlichen konturgleich mit den Funktionsmodulen 50a-50c sein kann, dient beispielsweise zur Ausgabe von Daten, die auf dem Datenbus 36 kommuniziert werden, beispielsweise Sensorsignale, Störungsmeldungen und dergleichen.

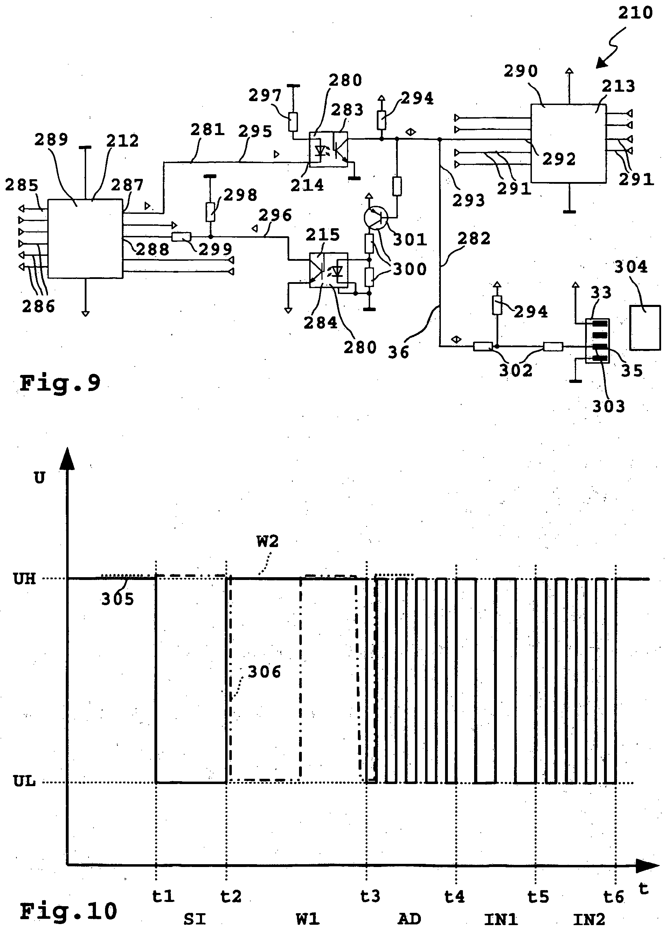

Auf dem Datenbus 36 ist eine konkurrierende Kommunikation mehrerer Kommunikationseinrichtungen, beispielsweise der Kommunikationseinrichtungen 289, 290 und 304, ohne weiteres möglich. Die Kommunikationseinrichtungen 289, 290, 304 kommunizieren mit unterschiedl-ichen Prioritäten auf dem Datenbus 36. Eine beispielhafte Kommunikation ist in Figur 10 dargestellt.

Beispielsweise sendet die zweite Kommunikationseinrichtung 290 eine Busnachricht 305 auf dem Datenbus 36. Die Busnachricht 305 beginnt mit einem Startimpuls SI. Dabei senkt die Kommunikationseinrichtung 290 ein Potential U auf dem Datenbus 36 von einem hohen Ruhepotential UH auf ein niedrigeres Sendepotential UL. Dabei ist festzuhalten, dass der Datenbus 36 als Offener-Kollektor-Bus ausgeführt ist. Mit dem Startimpuls SI signalisiert die Kommunikationseinrichtung 290 zum Zeitpunkt t1 den Wunsch, eine Busnachricht zu versenden. Zu einem Zeitpunkt t2 endet der Startimpuls und beginnt eine Wartephase W1, innerhalb derer die Kommunikationseinrichtung 290 auf Sendewünsche anderer Busteilnehmer des Datenbusses 36 wartet. Dies könnte beispielsweise eine Busnachricht 306 sein, deren Wartephase W2 kürzer ist als die Wartephase W1. Die im Vergleich zur Wartephase W1 kürzere Wartephase W2 signalisiert, dass die Busnachricht 306 eine höhere Priorität hat als die Busnachricht 305. In diesem Fall würde die Kommunikationseinrichtung 290 das weitere Senden der Busnachricht 305 unterlassen und der Busnachricht 306 den Vorrang geben.

Nachfolgend wird jedoch die Busnachricht 305 weiter beschrieben: Zu einem Zeitpunkt t3 beginnt eine Adressinformation AD, die beispielsweise die Art der Nachricht und/oder den Sender der Nachricht und/oder den Inhalt der Nachricht betrifft. Daran schließen sich zu Zeitpunkten t4 und t5 Informationsteile IN1, IN2 an, die beispielsweise vier oder acht Datenbits enthalten. Busnachrichten auf dem Datenbus 36 können variable Längen aufweisen, das heißt beispielsweise, dass nur der Informationsteil IN1 übertragen wird oder sich an den Informationsteil IN2 weitere, nicht dargestellte Informationsteile anschließen.

## Patentansprüche

1. Portable elektrische Maschine, insbesondere Hand-Werkzeugmaschine oder Sauggerät (10), mit einem Leiterplattenmodul (210), das eine Leiterplatte (123) aufweist, an der Leiterbahnen (220) und über die Leiterbahnen (220) elektrisch miteinander verbundene elektrische Komponenten (211) an zumindest einer Flachseite (218) angeordnet sind, wobei an der die elektrischen Komponenten (211) aufweisenden Flachseite (218) oder einer dieser entgegengesetzten Flachseite (219) der Leiterplatte (123) eine Leitkörperanordnung (243) mit mindestens einem von der Leiterplatte (123) separaten Leitkörper (238-242) angeordnet ist, und dass mindestens ein vor einen entlang der Flachseite (219) verlaufenden Leitkörper-Verbindungsabschnitt (253) vorstehender Leiterplatten-Kontaktvorsprung (247, 248) des mindestens einen Leitkörpers (238-242) die Leiterplatte (123) an einer Kontaktöffnung (245, 246) durchdringt oder in die Leiterplatte (123) eindringt, **dadurch gekennzeichnet, dass** zwischen dem mindestens einen Leitkörper (238-242) und der Leiterplatte (123) ein insbesondere plattenförmiger Zwischenkörper (260) und/oder an einer von der Leiterplatte (123) abgewandten Seite des mindestens einen Leitkörpers (238-242) ein insbesondere plattenförmiger oder wannenartiger Bodenkörper (261) angeordnet ist, und dass der Bodenkörper (261) und/oder der Zwischenkörper (260) eine Leitkörper-Aufnahme (265, 271) zur Aufnahme des mindestens einen Leitkörpers (238-242) aufweist, wobei der mindestens eine Leitkörper (238, 239, 241) mit seinen Flachseiten an Innenwänden der Leitkörper-Aufnahme (265) im Wesentlichen flächig anliegt.

2. Portable elektrischen Maschine nach Anspruch 1, **dadurch gekennzeichnet, dass** der mindestens eine Leiterplatten-Kontaktvorsprung (247, 248) als ein Steckvorsprung zum Anstecken eines elektrischen Steckverbinders (233, 251) ausgestaltet ist.

3. Portable elektrische Maschine nach Anspruch 1 oder 2, **dadurch gekennzeichnet, dass** der mindestens eine Leitkörper (238-242) mindestens einen Anschlussabschnitt (254, 255) aufweist, der zum elektrischen Anschluss einer weiteren Komponente, insbesondere eines Steckverbinders (233, 251), an mindestens einer Seite vor die Leiterplatte (123) vorsteht, wobei zweckmäßigerweise an dem Anschlussabschnitt (254, 255) mindestens ein Leitkörper-Steckanschluss (249, 250) für einen elektrischen Steckverbinder (233, 251) angeordnet ist.

4. Portable elektrische Maschine nach einem der vorhergehenden Ansprüche, **dadurch gekennzeichnet, dass** der mindestens eine Leitkörper-Steckanschluss (249, 250) und/oder der mindestens eine Leiterplatten-Kontaktvorsprung (247, 248) Bestandteile einer mehrpoligen Steckanschlussanordnung (234-237) zum Anschluss eines mehrpoligen elektrischen Steckverbinders (251) bilden, wobei die Steckanschlussanordnung (234-237) zweckmäßigerweise einen elektrisch ausschließlich mit der Leiterplatte (123) verbundenen, von dem mindestens einen Leitkörper (238-242) elektrisch isolierten Leiterplatten-Steckanschluss (257) aufweist.

5. Portable elektrische Maschine nach einem der vorhergehenden Ansprüche, **dadurch gekennzeichnet, dass** der Bodenkörper (261) und/oder der Zwischenkörper (260) eine die Leiterplatte (123) an zumindest einer Seite eingrenzende, insbesondere wannenartige, Seitenwand oder Umfangswand (263) aufweisen und/oder dass der Zwischenkörper (260) und/oder der Bodenkörper (261) elektrisch isolierend sind und/oder dass an dem Zwischenkörper (260) und/oder an dem Bodenkörper (261) und/oder an der Leiterplatte (123) ein Isolationskörper (276) zur elektrischen Isolation eines Steckanschlusses vorgesehen oder einstückig ausgebildet ist, wobei der Isolationskörper (276) zweckmäßigerweise einen Bestandteil eines Steckverbindergehäuses (277) bildet.

6. Portable elektrische Maschine nach einem der vorhergehenden Ansprüche, **dadurch gekennzeichnet, dass** sie mindestens eine insbesondere den mindestens einen Leitkörper (238-242) an dem Leiterplattenmodul (210) fixierende Vergussschicht aufweist.

7. Portable elektrische Maschine nach einem der vorhergehenden Ansprüche, **dadurch gekennzeichnet, dass** zumindest ein Abschnitt des mindestens einen Leitkörpers (238-242) und/oder der Zwischenkörper (260) und/oder die Leiterplatte (123) in einem insbesondere zumindest teilweise mit Vergussmasse verfüllten Wannenbereich (262) des Bodenkörpers (261) aufgenommen sind.

8. Portable elektrische Maschine nach einem der vorhergehenden Ansprüche, **dadurch gekennzeichnet, dass** der mindestens eine Leitkörper (238-242) eine Plattengestalt oder eine Flachgestalt aufweist.

9. Portable elektrische Maschine nach Anspruch 8, **dadurch gekennzeichnet, dass** eine Leitkörper-Flachseite des mindestens einen Leitkörpers (238-242) quer, insbesondere stumpfwinkelig oder senkrecht, zur benachbarten Flachseite (219) der Leiterplatte (123) verläuft.

10. Portable elektrische Maschine nach einem der vorhergehenden Ansprüche, **dadurch gekennzeichnet, dass** der Leiterplatten-Kontaktvorsprung (247, 248) und/oder der Leitkörper-Steckanschluss (249, 250) vor eine Schmalseite (244) des mindestens einen Leitkörpers (238-242) vorstehen.

11. Portable elektrische Maschine nach einem der vorhergehenden Ansprüche, **dadurch gekennzeichnet, dass** die mindestens eine Kontaktöffnüng (245, 246) bezüglich des mindestens einen Leiterplatten-Kontaktvorsprungs (247, 248) zumindest abschnittsweise, insbesondere im Querschnitt, schräg oder gebogen verläuft, so dass das der Leiterplatten-Kontaktvorsprung (247, 248) punktförmig, insbesondere in einer Dreipunktlage, an einer Innenkontur der mindestens einen Kontaktöffnung (245, 246) anliegt.

12. Portable elektrische Maschine nach einem der vorhergehenden Ansprüche, **dadurch gekennzeichnet, dass** die mindestens eine Kontaktöffnung (245, 246) eine sichelförmige oder im wesentlichen dreikantartige Innenkontur aufweist.

13. Portable elektrische Maschine nach einem der vorhergehenden Ansprüche, **dadurch gekennzeichnet, dass** an dem mindestens einen Leitkörper (238-242) mindestens eine mechanische Kodierung gegenüber einem an ihn angrenzendes, insbesondere ihn aufnehmendes oder haltendes, Bauteil, insbesondere gegenüber einer Leitkörper-Aufnahme (265, 271) zur Aufnahme des mindestens einen Leitkörpers (238-242), angeordnet ist.

14. Portable elektrische Maschine nach einem der vorhergehenden Ansprüche, **dadurch gekennzeichnet, dass** die Leitkörperanordnung (243) mehrere, insbesondere zumindest im wesentlichen parallel nebeneinander verlaufende, Leitkörper (238-242) aufweist.

## Claims

1. Portable electric machine, in particular hand-operated power tool or suction apparatus (10), comprising a circuit board module (210) having a printed circuit board (123), on which conductors (220) and electric components (211) electrically connected to one another via the conductors (220) are arranged on at least one flat side (218), wherein a conducting body assembly (243) with at least one conducting body (238 - 242) separate from the printed circuit board (123) is arranged on the flat side (218) having the electric components (211) or on an opposite flat side (219), and wherein at least one circuit board contact projection (247, 248) of the at least one conducting body (238 - 242), which projects in front of a conducting body connecting section (253) extending along the flat side (219), penetrates the printed circuit board (123) at a contact opening (245, 246) or penetrates into the printed circuit board (123), **characterised in that** an in particular plate-shaped intermediate body (260) is arranged between the at least one conducting body (238 - 242) and the printed circuit board (123) and/or an in particular plate-shaped or trough-like base body (261) is arranged on a side of the at least one conducting body (238 - 242) which is remote from the printed circuit board (123), and **in that** the base body (261) and/or the intermediate body (260) has/have a conducting body receptacle (265, 271) for the accommodation of the at least one conducting body (238 - 242), wherein the flat sides of the at least one conducting body (238, 239, 241) are substantially in surface contact with internal walls of the conducting body receptacle (265).

2. Portable electric machine according to claim 1, **characterised in that** the at least one circuit board contact projection (247, 248) is designed as a plug projection for plugging on an electric plug connector (233, 251).

3. Portable electric machine according to claim 1 or 2, **characterised in that** the at least one conducting body (238 - 242) has at least one connecting section (254, 255), which projects on at least one side in front of the printed circuit board (123) for the electric connection of a further component, in particular a plug connector (233, 251), wherein at least one conducting body plug connection (249, 250) for an electric plug connector (233, 251) is expediently arranged on the connecting section (254, 255).

4. Portable electric machine according to any of the preceding claims, **characterised in that** the at least one conducting body plug connection (249, 250) and/or the at least one circuit board contact projection (247, 248) is/are a part of a multipole plug connection assembly (234 - 237) for the connection of a multipole electric plug connector (251), wherein the plug connection assembly (234 - 237) expediently comprises a circuit board plug connection (257), which is electrically connected exclusively to the printed circuit board (123) and electrically insulated against the at least one conducting body (238 - 242).

5. Portable electric machine according to any of the preceding claims, **characterised in that** the base body (261) and/or the intermediate body (260) has/have an in particular trough-shaped side wall or circumferential wall (263) enclosing the printed circuit board (123) on at least one side, and/or **in that** the intermediate body (260) and/or the base body (261) is/are electrically insulating, and/or **in that** an insulating body (276) for the electric insulation of a plug connector is provided on or integrated with the intermediate body (260) and/or the base body (261) and/or the printed circuit board (123), the insulating body (276) expediently forming a part of a plug connector housing (277).

6. Portable electric machine according to any of the preceding claims, **characterised in that** is comprises at least one potting layer which secures the at least one conducting body (238 - 242) to the circuit board module (210) in particular.

7. Portable electric machine according to any of the preceding claims, **characterised in that** at least a section of the at least one conducting body (238 - 242) and/or the intermediate body (260) and/or the printed circuit board (123) is/are accommodated in a trough region (262) of the base body (261) which is in particular at least partially filled with a potting compound.

8. Portable electric machine according to any of the preceding claims, **characterised in that** the at least one conducting body (238 - 242) has a plate shape or a flat shape.

9. Portable electric machine according to claim 8, **characterised in that** a conducting body flat side of the at least one conducting body (238 - 242) extents transversely, in particular at an obtuse angle or perpendicular, to the adjacent flat side (219) of the printed circuit board (123).

10. Portable electric machine according to any of the preceding claims, **characterised in that** the circuit board contact projection (247, 248) and/or the conducting body plug connection (249, 250) project(s) in front of a narrow side (244) of the at least one conducting body (238 - 242).

11. Portable electric machine according to any of the preceding claims, **characterised in that** the at least one contact opening (245, 246) extends at least in sections, in particular in cross-section, at an angle or with a curvature relative to the at least one circuit board contact projection (247, 248), so that the circuit board contact projection (247, 248) is in contact with an internal contour of the at least one contact opening (245, 246) in a punctiform manner, in particular in a three-point position.

12. Portable electric machine according to any of the preceding claims, **characterised in that** the at least one contact opening (245, 246) has a crescent-shaped or substantially triangular internal contour.

13. Portable electric machine according to any of the preceding claims, **characterised in that** at least one mechanical coding with respect to an adjoining component which accommodates or holds it in particular, in particular with respect to a conducting body receptacle (265, 271) for the accommodation of the at least one conducting body (238 - 242), is arranged on the at least one conducting body (238 - 242).

14. Portable electric machine according to any of the preceding claims, **characterised in that** the conducting body assembly (243) comprises a plurality of conducting bodies (238 - 242), which extend at least substantially parallel next to one another in particular.

## Revendications

1. Machine électrique transportable, en particulier machine à outillage manuel ou appareil d'aspiration (10) comportant un module (210) muni d'une plaquette imprimée (123) sur laquelle des pistes conductrices (220), et des composants électriques (211) raccordés électriquement les uns aux autres par l'intermédiaire desdites pistes conductrices (220), sont disposés sur au moins un côté plat (218), sachant qu'un ensemble (243) de corps conducteurs, doté d'au moins un corps conducteur (238-242) distinct de la plaquette imprimée (123), est disposé sur ledit côté plat (218) pourvu desdits composants électriques (211), ou sur un côté plat (219) de ladite plaquette imprimée (123) qui est opposé au côté précité, et sachant qu'au moins une protubérance (247, 248) du corps conducteur (238-242) à présence minimale, instaurant une mise en contact de la plaquette imprimée et faisant saillie au-delà d'un tronçon (253) de raccordement dudit corps conducteur s'étendant le long dudit côté plat (219), traverse la plaquette imprimée (123) au niveau d'un orifice de contact (245, 246), ou pénètre dans ladite plaquette imprimée (123), **caractérisée par le fait qu'**un corps intermédiaire (260), notamment en forme de platine, est interposé entre la plaquette imprimée (123) et le corps conducteur (238-242) à présence minimale, et/ou qu'un corps d'embase (261), notamment en forme de platine ou du type cuvette, est placé sur un côté dudit corps conducteur (238-242) à présence minimale qui est tourné à l'opposé de ladite plaquette imprimée (123) ; et **par le fait que** ledit corps d'embase (261), et/ou ledit corps intermédiaire (260), comporte(nt) un logement (265, 271) conçu pour recevoir le corps conducteur (238-242) à présence minimale, sachant que le corps conducteur (238, 239, 241) à présence minimale repose pour l'essentiel en applique, par ses côtés plats, contre des parois intérieures dudit logement (265) recevant ledit corps conducteur.

2. Machine électrique transportable selon la revendication 1, **caractérisée par le fait que** la protubérance (247, 248) à présence minimale, instaurant une mise en contact de la plaquette imprimée, est conçue sous la forme d'une protubérance d'enfichage dédiée à l'emboîtement d'un connecteur électrique enfichable (233, 251).

3. Machine électrique transportable selon la revendication 1 ou 2, **caractérisée par le fait que** le corps conducteur (238-242), à présence minimale, est doté d'au moins un tronçon de raccordement (254, 255) faisant saillie au-delà de la plaquette imprimée (123), sur au moins un côté, en vue du raccordement électrique d'un composant supplémentaire et notamment d'un connecteur enfichable (233, 251), au moins une connexion enfichable (249, 250) dudit corps conducteur, dévolue à un connecteur électrique enfichable (233, 251), étant commodément disposée sur ledit tronçon de raccordement (254, 255).

4. Machine électrique transportable selon l'une des revendications précédentes, **caractérisée par le fait que** la connexion enfichable (249, 250) à présence minimale sur le corps conducteur, et/ou la protubérance (247, 248) à présence minimale, instaurant une mise en contact de la plaquette imprimée, fait (font) partie intégrante d'un ensemble multipolaire (234-237) de connexion par enfichage, dévolu au raccordement d'un connecteur électrique enfichable multipolaire (251), ledit ensemble (234-237) de connexion par enfichage étant commodément muni d'une connexion enfichable (257) affectée à la plaquette imprimée, en liaison électrique exclusive avec ladite plaquette imprimée (123) et isolée électriquement d'avec le corps conducteur (238-242) à présence minimale.

5. Machine électrique transportable selon l'une des revendications précédentes, **caractérisée par le fait que** le corps d'embase (261), et/ou le corps intermédiaire (260), comporte(nt) une paroi latérale ou une paroi périphérique (263) notamment du type cuvette, marquant la délimitation de la plaquette imprimée (123) sur au moins un côté ; et/ou **par le fait que** ledit corps intermédiaire (260) et/ou ledit corps d'embase (261) est (sont) électriquement isolant(s) ; et/ou **par le fait qu'**un corps d'isolation (276) est prévu sur ledit corps intermédiaire (260) et/ou sur ledit corps d'embase (261) et/ou sur ladite plaquette imprimée (123), ou fait corps avec ces derniers, en vue de l'isolation électrique d'une connexion enfichable, ledit corps d'isolation (276) faisant commodément partie intégrante d'un boîtier (277) de connecteurs enfichables.

6. Machine électrique transportable selon l'une des revendications précédentes, **caractérisée par le fait qu'**elle comporte au moins une couche de scellement assurant notamment le blocage à demeure du corps conducteur (238-242), à présence minimale, sur le module (210) à plaquette imprimée.

7. Machine électrique transportable selon l'une des revendications précédentes, **caractérisée par le fait qu'**au moins un tronçon du corps conducteur (238-242) à présence minimale, et/ou le corps intermédiaire (260), et/ou la plaquette imprimée (123), est (sont) logé(e)(s) dans une région encaissée (262) du corps d'embase (261) qui est notamment comblée, au moins en partie, par une masse de scellement.

8. Machine électrique transportable selon l'une des revendications précédentes, **caractérisée par le fait que** le corps conducteur (238-242), à présence minimale, offre une configuration en forme de platine ou une configuration aplatie.

9. Machine électrique transportable selon la revendication 8, **caractérisée par le fait qu'**un côté plat du corps conducteur (238-242) à présence minimale s'étend transversalement, en particulier à angle obtus ou à angle droit par rapport au côté plat contigu (219) de la plaquette imprimée (123).

10. Machine électrique transportable selon l'une des revendications précédentes, **caractérisée par le fait que** la protubérance (247, 248) de mise en contact de la plaquette imprimée, et/ou la connexion enfichable (249, 250) située sur le corps conducteur, dépasse(nt) au-delà d'un petit côté (244) dudit corps conducteur (238-242) à présence minimale.

11. Machine électrique transportable selon l'une des revendications précédentes, **caractérisée par le fait que** l'orifice de contact (245, 246) à présence minimale offre, au moins par zones et notamment en coupe transversale, un tracé oblique ou arqué par rapport à la protubérance (247, 248) à présence minimale, instaurant une mise en contact de la plaquette imprimée, de telle sorte que ladite protubérance (247, 248) de mise en contact de la plaquette imprimée porte ponctuellement, en particulier dans une position à trois points, contre un profil intérieur dudit orifice de contact (245, 246) à présence minimale.

12. Machine électrique transportable selon l'une des revendications précédentes, **caractérisée par le fait que** l'orifice de contact (245, 246), à présence minimale, est pourvu d'un profil intérieur en forme de croissant ou, pour l'essentiel, du type à trois pans.

13. Machine électrique transportable selon l'une des revendications précédentes, **caractérisée par le fait que** le corps conducteur (238-242), à présence minimale, est muni d'au moins un codage mécanique par rapport à un élément structurel qui est limitrophe dudit corps et est destiné, en particulier, à le recevoir ou à le retenir, notamment par rapport à un logement (265, 271) conçu pour recevoir ledit corps conducteur (238-242) à présence minimale.

14. Machine électrique transportable selon l'une des revendications précédentes, **caractérisée par le fait que** l'ensemble (243) de corps conducteurs comprend plusieurs corps conducteurs (238-242) s'étendant notamment, au moins pour l'essentiel, en juxtaposition parallèle.
